# EUROPEAN PATENT APPLICATION

(11) **EP 1 814 254 A1**
(43) Date of publication of application: **01.08.2007**
(21) Application number: 06290171.5
(22) Date of filing: 26.01.2006
(51) Int. Cl.: H04L 7/02, H03L 7/091, H04L 25/03

(54) **Binary phase detector and clock data recovery device**

(71) Applicant: Alcatel Lucent, 75008 Paris (FR)
(72) Inventor: Franz, Bernd, 74336 Brackenheim (DE)
(74) Representative: Kohler Schmid Möbus

(57) **Abstract**

A binary phase detecting device (2) comprises a first decision feedback equaliser (DFE1) connected in parallel with a decision unit (DFE2), which can be devised as a second decision feedback equaliser. Respective outputs (Q) of the first decision feedback equaliser and the decision unit are input to a first (8) and to a second flip flop (9), respectively. Using this configuration, the proposed binary phase detecting device overcomes disadvantages of conventional binary phase detectors in the presence of highly distorted input signals, e.g. due to Polarisation Mode Dispersion (PMD), thus enabling high-performance clock data recovery (CDR) with increase dispersion tolerance.

## Description

### Background of the invention

The invention relates to a binary phase detecting device and to a clock data recovery device comprising such binary phase detecting device.

Furthermore, the present invention relates to a method of recovering clock data from a binary data signal.

Devices for recovering clock data from a binary data signal generally comprise a phase detector, such as a binary phase detector, which generates an output signal depending on a phase difference of a clock and a non-regenerated data signal. A common example of a prior art binary phase detector is the Alexander or bang-bang binary phase detector (binary PD), which uses a configuration of four simple decision flip flops (DFFs). When compared to commonly known linear phase detectors, binary phase detectors have the advantage of delivering output pulses with a duration of one bit period which indicate a leading or a lagging clock phase. Such a behaviour is advantageous especially for high speed data transmission.

However, the transfer function of conventional phase detectors (linear or binary), such as the above-mentioned Alexander phase detector, is sensitive to the number and amplitude of data transitions (0 to 1, and vice versa) in the binary data signal. For instance, in the case of a heavily distorted data signal with a differential group delay (DGD) of 100% and a power splitting factor ┌ = 0.5, there are only half as many transitions with only half the signal amplitude for each transistion, when compared with a non-distorted data signal. This has negative implications on the performance of clock data recovery (CDR), i.e. jitter tolerance, jitter transfer function, and output clock jitter will be concerned. Thus, clock jitter will increase which results in reduced jitter tolerance.

### Object of the invention

It is the object of the present invention to provide a dispersion tolerant binary phase detector, thus enabling an improved performance of binary phase detecting and clock data recovery devices.

### Description of the invention

According to a first aspect of the present invention, this object is achieved by providing a binary phase detecting device comprising a first decision feedback equaliser and a decision unit connected in parallel with the first decision feedback amplifier, wherein respective outputs of the first decision feedback equaliser and the decision unit are input to a first and to a second flip flop, respectively.

In accordance with a second aspect of the present invention, the object is also achieved by a clock data recovery device comprising the binary phase detecting device according to said first aspect of the present invention, further comprising a data input terminal for inputting a binary data signal and a reference clock for inputting a clock signal into the binary phase detecting device, wherein a binary transfer signal of the binary phase detecting device is fed to a charge pump, said charge pump being further connected with said reference clock for controlling a characteristic thereof.

According to a third aspect of the present invention, the object is also achieved by a method of recovering clock data from a binary data signal, comprising the steps of feeding the data signal to a first decision feedback equaliser and to a decision unit, and feeding respective outputs of the first decision feedback equaliser and the decision unit to a first flip flop and to a second flip flop, respectively.

Thus, in accordance with the basic idea of the present invention at least a first decision feedback equaliser (DFE) is used instead of a simple decision flip flop (DFF) in the case of conventional binary phase detectors, which effectively provides a shift of the input data signal which leads to an improved (binary) behaviour of the transfer curve of the inventive binary phase detecting device, even in the presence of a highly distorted data signal, e.g. due to PMD. This also leads to improve CDR performance.

In another embodiment of the binary phase detecting device in accordance with the present invention the decision unit is devised as a second decision feedback equaliser. Controlling of the first and / or second decision feedback equalisers can be achieved using a least mean squares (LMS) algorithm, said algorithm preferably being performed by a control unit, which compares the input and output signals of the decision feedback equalisers and accordingly determines suitable control parameters for the decision feedback equalisers by minimising squares of the deviation between these two signals.

Alternatively, in a further embodiment of the binary phase detecting device in accordance with the present invention the decision unit can be devised as a decision flip flop (DFF), thus simplifying the overall design of the inventive device.

In a further embodiment of the binary phase detecting device in accordance with the present invention at least the first decision feedback equaliser comprises a flip flop, an output of which is connected by means of a feedback path with an input of said flip flop. In yet another embodiment of the binary phase detecting device in accordance with the present invention the feedback path comprises a multiplier effectively serving as a feedback filter and adapted to multiply the output of the flip flop with at least one weighting coefficient C. As already stated above, said coefficient is preferably determined using an LMS algorithm performed by said control unit and is generally comprised between 0 and 0.5, i.e. 0 < C < 0.5. In embodiments of the invention which further comprise a second decision feedback equaliser, the latter as well as its respective feedback path are preferably devised in a similar fashion.

In the above-described embodiments the decision feedback equaliser has been devised as an analog feedback equaliser. Alternatively, in another embodiment in accordance with the present invention at least the first decision feedback equaliser could be devised as a digital feedback equaliser comprising two flip flops connected in parallel and respectively coupled to a multiplexer connected in series with another flip flop, as known to a person skilled in the art and as described, e.g., in the publication "Techniques for High-speed Implementation of Non-linear Cancellation", Kasturia et al., IEEE Journal on Selected Areas in Communications, Vol. 9, No. 5, June 1991, pp. 711-717, the complete contents of which is hereby incorporated by reference into the present document. In embodiments of the invention which further comprise a second decision feedback equaliser, the latter is preferably devised in a similar fashion.

In another embodiment of the binary phase detecting device in accordance with the present invention, respective outputs of the first decision feedback equaliser and the second flip flop are combined at a first logical gate, in particular an XOR gate. Furthermore, respective outputs of the first and second flip flops are combined at a second logical gate, in particular an XOR gate. In addition, respective outputs of the first and second logical gates are combined to yield a binary transfer signal. As already mentioned above, the binary transfer signal indicates leading and lagging clock phases, respectively, and can be used for CDR applications.

In yet another embodiment of the binary phase detecting device in accordance with the present invention, the first decision feedback equaliser, the decision unit and the first and second flip flops are connected with a reference clock, an inverter being further located in a signalling path from the reference clock to the decision unit. Advantageously, the reference clock is devised as voltage controlled oscillator (VCO).

Further advantages and characteristics of the present invention can be gathered from the following description of preferred embodiments given by way of example only with reference to the enclosed drawings. The features mentioned above as well as below can be used in accordance with the invention either individually or in conjunction. The embodiments mentioned are not to be understood as an exhaustive enumeration but rather as examples with regard to the underlying concept of the present invention.

### Drawings

- Fig. 1: is a circuit diagram of a preferred embodiment of the clock data recovery device in accordance with the present invention comprising the binary phase detecting device in accordance with the present invention;
- Fig. 2: is a diagram showing transfer functions of the binary phase detecting device in accordance with the present invention as comprised in the clock data recovery device of Fig. 1 in comparison with prior art phase detectors; and
- Fig. 3: is a highly schematic of an alternative embodiment of the clock data recovery device in accordance with the present invention in combination with a further data recovery unit comprising an eye monitor.

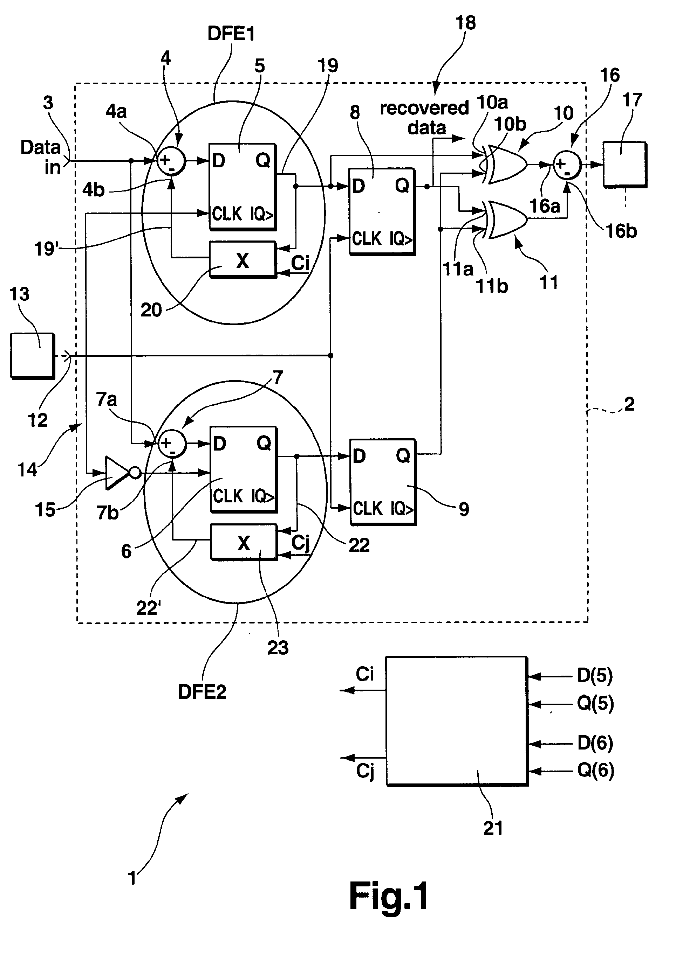

**Fig. 1** shows an electrical circuit diagram of a clock data recovery device **1** in accordance with the present invention. The clock data recovery device 1 includes a binary phase detecting device **2** in accordance with the present invention. In the following and without limitation, individual features of the present invention will be described in terms of the clock data recovery device 1, although a number of these features may also be associated with the inventive binary phase detecting device 2.

The clock data recovery device 1 has a data input terminal **3** for supplying a binary data signal for clock data recovery therefrom. Data input terminal 3 is connected via a first summation circuit **4** having input **4a** (+) and inverting input **4b** (-) with the D input of flip flop **5** (decision / delay flip flop; DFF). In parallel, data input terminal 3 is connected with the D input of DFF **6** via summation circuit **7** having input **7a** (+) and inverting input **7b** (-). Output Q of DFF 5 is connected with the D input of further DFF **8,** while output Q of DFF 6 is connected with the D input of yet another DFF **9.** Respective outputs Q of DFF 5 and DFF 9 are connected with respective input terminals **10a, 10b** of a first logical gate in the form of an exclusive OR (XOR) gate **10,** while respective outputs Q of DFF 8 and DFF 9 are connected with respective input terminals **11a, 11b** of a second logical gate in the form of an exclusive OR gate (XOR) **11.**

Furthermore, the clock data recovery device 1 has a clock input terminal **12** for a clock signal from a reference clock in the form of a voltage controlled oscillator **13** (VCO). Clock input terminal 12 is connected with respective clock (CLK) inputs of DFF 5, DFF 8, and DFF 9. In a signalling path **14** from the VCO 13, i.e. clock input terminal 12 to a CLK input of DFF 6 there is provided an inverter **15** for inverting the reference clock signal prior to feeding into the CLK input of DFF 6.

Respective outputs of the first and second XOR gates 10, 11 are combined by means of further summation circuit **16** having input **16a** (+) and inverting input **16b** (-). Summation circuit 16 is connected with a charge pump **17,** the latter being further connected with the VCO 13 for controlling at least one characteristic, e.g. the frequency, thereof. However, said combination of outputs need not necessarily be done using summation circuit 16, another possibility is to combine the signals from XOR gates 10, 11 within the charge pump 17, thus omitting summation circuit 16. In the shown embodiment, between outputs Q of DFF 8 and a corresponding input terminal 11a of second XOR gate 11 there is provided a further circuit branch **18** for recovering the data input at terminal 3.

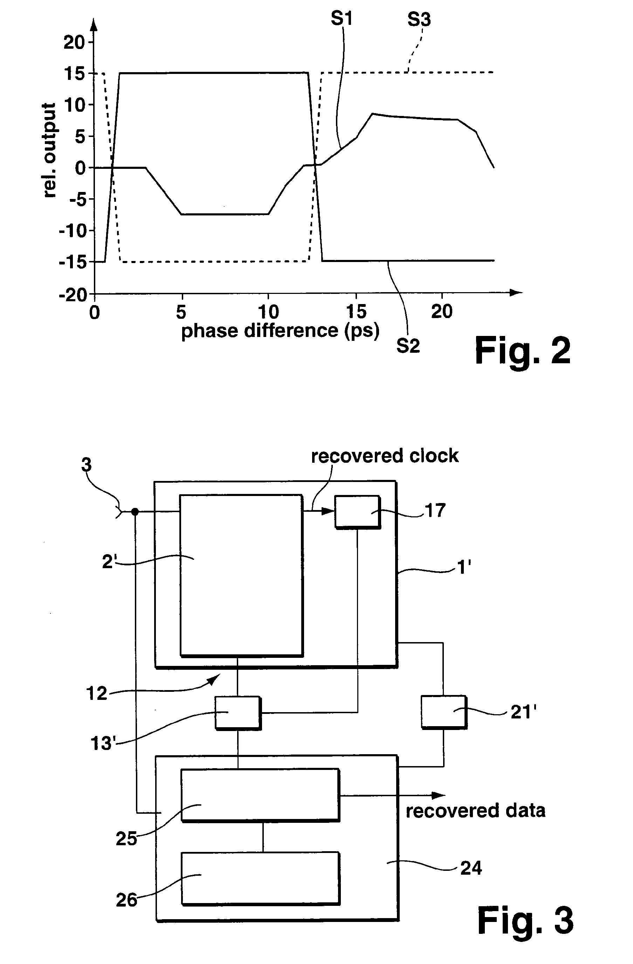

As described so far, the configuration of clock data recovery device 1 corresponds to that of a conventional clock data recovery device using an Alexander (bang-bang) phase detector, the functioning of which is known to a person skilled in the art. In contrast to this and in accordance with the present invention, the clock data recovery device 1 of Fig. 1 additionally comprises a feedback path **19, 19',** connecting output Q of DFF 5 with the D input of the same DFF 5 via the inverting input 4b of summation circuit 4. In the feedback path 19, 19' there is provided a multiplier **20** for weighting the output of DFF 5 with a coefficient Ci prior to feedback to DFF 5. In accordance with the present invention, the weighting factor Ci is determined by control unit **21** and preferably comprised between 0 and 0.5. To this end, the control unit 21 is operatively connected for to receive the signal input to DFF 5 as well as the output signal of DFF 5, denoted D(5) and Q(5), respectively, in Fig. 1. In this way, DFF 5 and multiplier 20 - functioning as a feedback filter - together with summation circuit 4 effectively constitute a one-tap decision feedback equaliser (DFE1), as indicated by means of solid line circle labelled DFE1 in Fig. 1. The feedback signal of DFE1 effectively shifts the data signal input at terminal 3 with respect to, for instance, amplitude and / or phase and thus helps to recover the typical transfer curve of a binary phase detector (PD) even in the presence of heavily distorted data signals, as will be explained farther below with respect to Fig. 2.

In the embodiment of Fig. 1, a further feedback path **22, 22'** is provided linking output Q with D inputs of DFF 6, wherein a further multiplier **23** is located in feedback path 22, 22' for multiplying the output signal of DFF 6 with a suitable coefficient Cj prior to feedback via the inverting input 7b of summation circuit 7. As explained above with respect to coefficient Ci, coefficient Cj, too, is determined by control unit 21 and preferably comprised between 0 and 0.5. To this end, the control unit 21 is operatively connected for to receive the signal input to DFF 6 as well as the output signal of DFF 6, denoted D(6) and Q(6), respectively, in Fig. 1. In this way, the combination of DFF 6, multiplier 23 and summation circuit 7 effectively functions as a decision unit which is devised as another decision feedback equaliser denoted DFE2 in Fig. 1.

The combined binary transfer signal downstream of summation circuit 16 is integrated by the charge pump 17 and contains binary information as to whether the clock (VCO) 13 is early or late with respect to the clock data comprised in the data signal. As known to a person skilled in the art, said information can be used to control the VCO 13 and thus establish a CDR lock, such that data input at terminal 3 can be recovered at branch 18.

In the scope of the above-described embodiment of Fig. 1, the decision feedback equalisers DFE1, DFE2 are single-tap equalisers suitable, for instance, for single-mode data transmission of optical data signals. In principle, in particular for multimode transmission, providing decision feedback equalisers with a higher number of taps is equally possible.

The decision feedback equalisers DFE1, DFE2 of Fig. 1 can also be referred to as analog decision feedback equalisers. As will be appreciated by a person skilled in the art, the decision feedback equalisers DFE1, DFE2 might in principle alternatively be devised as digital decision feedback equalisers, as stated above.

**Fig. 2** shows transfer curves of a conventional binary PD in comparison with the binary PD 2 in as comprised in the clock data recovery device 1 in accordance with the present invention. The data signal input at terminal 3 is assumed to be heavily distorted, e.g. due to Polarisation Mode Dispersion (PMD), i.e. 100% DGD (Differential Group Delay), and a power splitting factor between orthogonally polarised modes of ┌= 0.5. This means, that there are only half as many data transitions with only half of the normal amplitude compared with a non-distorted data signal. In Fig. 2, the solid black curve labelled S1 illustrates the performance of a conventional binary PD in case of a distorted data signal as described above. In Fig. 2, a relative output in arbitrary units is plotted versus the phase difference measured in picoseconds (ps). The transfer curve S1 is no longer binary and presents reduced output levels, thus resulting in decreased CDR performance due to imperfect / ambiguous phase detection. Employing the binary phase detector 2 as proposed in the present document, which comprises at least one decision feedback equaliser instead of simple D flip flops, the solid binary curve labelled S2 is obtained. Curve S2 shows the binary behaviour required for high-performance CDR. Please note that in Fig. 2 curve S2 has been shifted by 180°, i.e. inverted, for better visibility. Furthermore, the dashed curve S3 in Fig. 2 illustrates the theoretical transfer curve for the prior art binary PD with an undistorted binary data signal at its input. As can be gathered from the present figure, the performance under distortion of the binary PD proposed here, approaches the performance of the prior art PD without distortions.

As will be appreciated from the description of Fig. 1 given above, the shown embodiment of the clock data recovery device 1 is employed for to recover both the the binary data input at terminal 3 itself (via branch 18) as well as the clock data comprised therein. **Fig. 3** schematically shows an alternative embodiment in accordance with the present invention, wherein actual data recovery is achieved by means of a further data recovery unit **24** to be described in the following. In Fig. 3, like elements with respect to Fig. 1 have been assigned the same reference numerals.

According to Fig. 3, a clock data recovery device **1'** is provided, which further comprises a binary phase detecting device **2'**. The binary phase detecting device 2' is identical to binary phase detecting device 2 of Fig. 1 but for the exception that there is no data recovery branch (cf. reference numeral 18 in Fig. 1) provided in the binary phase detecting device 2' of Fig. 3. In parallel with the clock data recovery device 1', there is provided said data recovery unit **24**, which is preferably realised in the form of a decision feedback equaliser **25** with analog feedback (cf. above) and an eye monitor **26** connected in parallel with the DFE 25 for optimising control / filter parameters, such as thresholds and / or filter coefficients of the DFE 25. Such a unit is has been described in European Patent Application 05291661.6 with titel "Receiver for an optical signal", filed on 02 August 2005 in the name of the present applicant, the complete disclosure of which is herewith incorporated by reference in the present document. As can be gathered from Fig. 3, the binary phase detecting device 2' is thus used exclusively for clock recovery, whereas the data recovery unit 24 is used for any further data recovery from the binary input signal.

Preferably and without limitation, the binary phase detecting device 2' and the data recovery unit 24 share a common reference clock (VCO) **13'** as well as a common control unit **21'**.

## Claims

1. A binary phase detecting device (2), comprising:
- a first decision feedback equaliser (DFE1), and
- a decision unit (DFE2) connected in parallel with the first decision feedback equaliser,
wherein respective outputs (Q) of the first decision feedback equaliser and the decision unit are input to a first flip flop (8) and a second flip flop (9), respectively.

2. The device of claim 1, wherein the decision unit (DFE2) is a second decision feedback equaliser.

3. The device of claim 1, wherein the decision unit is a decision flip flop.

4. The device of claim 1, wherein at least the first decision feedback equaliser (DFE1) comprises a flip flop (5), an output (Q) of said flip flop being connected by means of a feedback path (19, 19') with an input (D) of said flip flop.

5. The device of claim 4, wherein the feedback path (19, 19') comprises a multiplier (20) adapted to multiply the output of the flip flop (5) with at least one weighting coefficient (Ci).

6. The device of claim 1, wherein at least the first decision feedback equaliser(DFE1) comprises two flip flops connected in parallel and respectively coupled to a multiplexer.

7. The device of claim 1, wherein a respective output (Q) of the first decision feedback equaliser (DFE1) and the second flip flop (9) are combined at a first logical gate, in particular an XOR gate (10), wherein a respective output of the first (8) and second flip flops (9) are combined at a second logical gate, in particular an XOR gate (11), and wherein respective outputs of the first (10) and second logical gates (11) are combined to yield a binary transfer signal.

8. The device of claim 1, wherein the first decision feedback equaliser (DFE1), the decision unit (DFE2), and the first (8) and second flip flops (9) are connected with a reference clock (13), an inverter (15) being further located in a signalling path (14) from the reference clock (13) to the decision unit (DFE2).

9. A clock data recovery device (1) comprising a binary phase detecting device (2) according to any one of claims 1 to 8, a data input terminal (3) for inputting a binary data signal and a reference clock (13) for inputting a clock signal into the binary phase detecting device (2), wherein a binary transfer signal of the binary phase detecting device (2) is fed to a charge pump (17), said charge pump being further connected with the reference clock (13) for controlling a characteristic thereof.

10. A method of recovering clock data from a binary data signal, comprising the steps of:
- feeding the binary data signal to a first decision feedback equaliser (DFE1) and to a decision unit (DFE2),
- feeding respective outputs (Q) of the first decision feedback equaliser (DFE1) and the decision unit (DFE2) to a first flip flop (8) and to a second flip flop (9), respectively.
